# FASCICULE DE BREVET EUROPEEN

(11) **EP 0 463 956 B1**
(45) Date de publication et mention de la délivrance du brevet: **02.10.1996**
(21) Numéro de dépôt: 91401709.0
(22) Date de dépôt: 25.06.1991
(51) Int. Cl.: H01L 21/768, H01L 23/528

(54) **Procédé de réalisation d'un étage d'un circuit intégré**
Verfahren zum Herstellen einer Stufe in einer integrierten Schaltung
Method for making one stage of an integrated circuit

(30) Priorité: 26.06.1990 FR 9008011
(43) Date de publication de la demande: 02.01.1992
(73) Titulaire: COMMISSARIAT A L'ENERGIE ATOMIQUE, 75015 Paris (FR)
(72) Inventeur: Heitzmann, Michel, F-38190 Crolles (FR); Lajzerowicz, Jean, F-38240 Meylan (FR); Laporte, Philippe, F-38360 Sassenage (FR)
(74) Mandataire: Ilgart, Jean-Christophe

(56) Documents cités:
- EP-A- 0 224 013
- EP-A- 0 288 802
- IBM TECHNICAL DISCLOSURE BULLETIN. vol. 29, no. 3, août 1986, NEW YORK US pages 1211 - 1212; "INTEGRATED CIRCUIT CONDUCTOR LINE SELF ALIGNED TO CONTACT OPENINGS"

## Description

L'invention a trait à un procédé de réalisation d'un étage d'un circuit intégré, cet étage étant constitué de lignes d'interconnexion et de points de connexion qui relient les lignes d'interconnexion à des parties conductrices du circuit intégré situées sous l'étage. Une couche de matériau diélectrique emplit les volumes inoccupés par les lignes et les points de connexion.

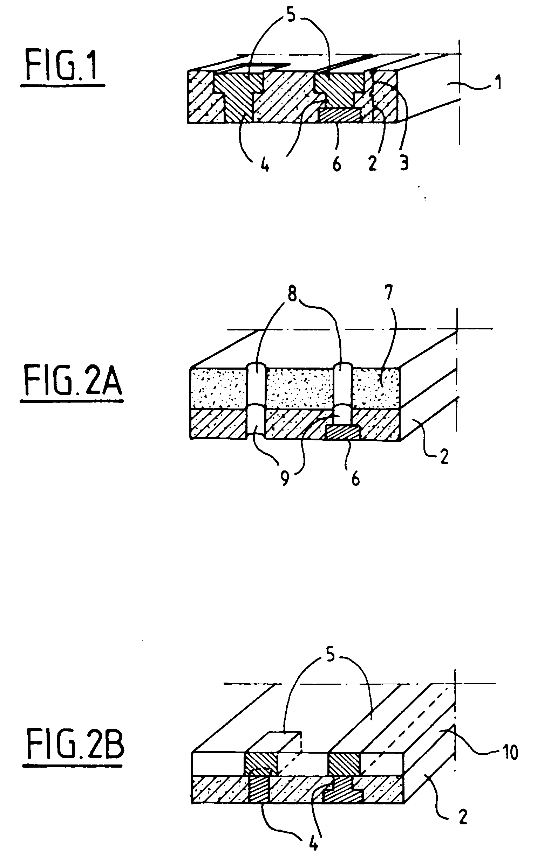

La figure 1 représente un tel étage de circuit intégré, et les étapes d'un procédé déjà connu pour sa fabrication sont exposées sur les figures 2A et 2B.

La couche diélectrique 1 peut en fait être décomposée en deux sous-couches superposées 2 et 3 telles que les points de connexion 4 s'étendent dans la sous-couche inférieure 2 et les lignes d'interconnexion 5 dans la sous-couche supérieure 3.

Les points de connexion 4 relient les lignes d'interconnexion 5 à des parties conductrices du circuit intégré qui peuvent être en particulier des zones de sources ou de drains ou des grilles 6 situées en dessous de la couche diélectrique 1.

Le procédé classique consiste tout d'abord à déposer la sous-couche inférieure 2, puis à déposer par-dessus une couche de résine 7 continue. On procède ensuite à la lithographie de la couche de résine 7 pour former des cavités 8 aux emplacements au-dessus des points de connexion 4, et réaliser ainsi un masque, après quoi il est possible de graver la sous-couche inférieure 2 pour former des cavités 9 aux emplacements des points de connexion 4. On arrive à l'état de la figure 2A. Après avoir retiré le masque, on dépose du matériau conducteur sur la sous-couche inférieure 2 de manière à combler les cavités 9 et créer ainsi les points de connexion 4 ainsi qu'une couche conductrice supérieure 10 qui recouvre la sous-couche inférieure 2. Ensuite, une gravure de la couche conductrice supérieure 10 permet de ne laisser subsister de celle-ci que les lignes d'interconnexion 5. Cet état est représenté sur la figure 2B. Les intervalles entre les lignes d'interconnexion 5 sont alors comblés par un dépôt diélectrique pour constituer la sous-couche supérieure 3. S'il le faut, les lignes d'interconnexion 5 sont recouvertes par une couche de passivation non représentée.

L'inconvénient fondamental de cette façon de procéder est que la couche de recouvrement 10 ne peut être parfaitement plane et présente des creux au-dessus des points de connexion 4. Si les cavités 9 sont à facteur de forme (rapport profondeur/diamètre) élevé, le creusement est tel qu'il est impossible d'obtenir avec certitude des lignes d'interconnexion 5 qui soient aptes à transmettre l'électricité de façon satisfaisante. Ce procédé limite donc la densité d'intégration du circuit en empêchant de réduire la largeur des lignes d'interconnexion 5 et le diamètre des points de connexion 4 autant qu'on le souhaiterait.

Plusieurs variantes du procédé ont été proposées pour remédier à ces inconvénients. On a ainsi envisagé l'emploi, pour constituer les points de connexion 4 et les lignes d'interconnexion 5, de certains matériaux qui se prêtent à des dépôts dont la surface supérieure est automatiquement plane, notamment le tungstène ou le silicium polycristallin par dépôt chimique en phase de vapeur, mais la conductivité de ces matériaux est faible et il faut donc prévoir des lignes d'interconnexion 5 plus épaisses. On a encore proposé, après avoir établi la couche de recouvrement 10 avec ces procédés, de la supprimer entièrement par gravure pour ne laisser subsister que les points de connexion 4. On procède alors au dépôt de la sous-couche supérieure 3, à sa gravure aux emplacements des lignes d'interconnexion 5 et enfin à un dépôt d'un métal conducteur tel que l'aluminium de manière à recouvrir la sous-couche supérieure 3 gravée. Il est ensuite facile de supprimer l'aluminium en dessus de la sous-couche supérieure 3 pour obtenir l'étage de la figure 1. Il est cependant clair que la nécessité de déposer le matériau conducteur en deux fois est désavantageuse.

L'usage de l'invention permet essentiellement de réaliser un étage de circuit intégré qui ne présente pas de relief excessif et dont la fabrication n'implique cependant qu'un dépôt unique de matériau conducteur.

Le procédé est formé par la succession des étapes suivantes telles que définies avec plus de précision dans la revendication 1 :
- dépôt d'une couche continue formant la couche diélectrique (c'est-à-dire que les sous-couches 2 et 3 sont déposées à cette étape) ;
- gravure au moins partielle de la couche diélectrique aux emplacements des points de connexion après avoir établi un premier masque sur la couche diélectrique ;
- puis, gravure finale de la couche diélectrique aux emplacements des points de connexion et de la sous-couche supérieure après avoir établi un second masque sur la couche diélectrique ;
- dépôt d'un matériau conducteur sur la couche diélectrique de manière à combler les parties gravées et former ainsi les points de connexion et les lignes d'interconnexion ; et
- élimination du matériau conducteur en dessus de la couche diélectrique.

L'article d'"IBM Technical Disclosure Bulletin", vol.29, n°3, août 1986, pp. 1211-1212 intitulé "lntegrated circuit conductor line self-aligned to contact opening" décrit un procédé de réalisation d'un circuit intégré semblable avec deux masques et deux étapes de gravure mais un ordre d'étapes différent. Dans l'invention, les deux masques sont déposés avant de graver la couche diélectrique, le second masque (percé aux lignes d'interconnexion) sur le premier (percé aux points de connexion).

Une réalisation améliorée consiste à prévoir un premier masque qui comprend une couche de recouvrement directement sur la couche diélectrique. Le second masque est alors établi sur la couche de recouvrement avant de commencer la gravure de la couche diélectrique aux emplacements des points de connexion. La surface sur laquelle on établit le second masque est alors presque plane.

Le matériau conducteur peut être choisi, comme on l'a vu, propre à former automatiquement une surface supérieure plane quand il est déposé.

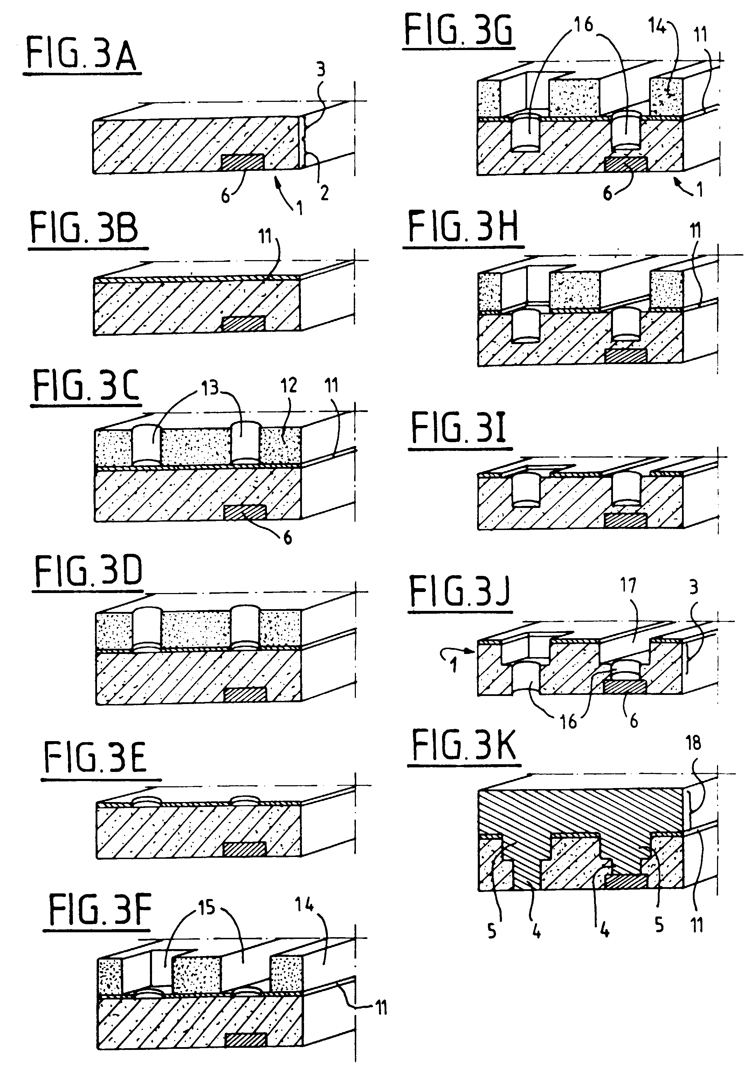

On va maintenant décrire plus en détail une mise en oeuvre possible du procédé, illustrative et non limitative, à l'aide des figures 3A à 3K annexées.

On forme d'abord les deux sous-couches 2 et 3 continues formant la couche diélectrique 1 par le dépôt sur les grilles 6 ou les parties conductrices inférieures d'une couche d'oxyde de silicium enrichi au verre de boro-phospho-silicate d'une épaisseur totale de 1,5 micromètre et qui est ensuite recuite pour la rendre plane et arriver à l'état de la figure 3A.

Une couche de recouvrement 11, qui peut être du silicium polycristallin de 200 nanomètres d'épaisseur est ensuite déposée sur la sous-couche supérieure 3 (figure 3B).

Une couche de résine 12 continue est alors déposée sur la couche de recouvrement 11 puis soumise à une lithographie qui creuse des cavités 13 au-dessus des emplacements des points de connexion 4, jusqu'à arriver à la couche de recouvrement 11 (figure 3C).

L'étape suivante consiste à graver la couche de recouvrement 11 aux emplacements des cavités 13 (figure 3D), après quoi la couche de résine 12 est éliminée (figure 3E).

Il est alors possible (figure 3F) de former sur la couche de recouvrement 11 une seconde couche de résine 14 qui est soumise, après avoit été déposée, à une lithogravure de manière à former des cavités 15 sur les emplacements des lignes d'interconnexion 5 qui seront bientôt établies.

L'étape suivante, représentée sur la figure 3G, consiste à graver la couche diélectrique 1 aux emplacements des points d'interconnexion 4, sur une profondeur partielle d'environ 700 nanomètres par exemple, pour y créer des cavités 16 ; la couche de recouvrement 11 fait office de premier masque en protégeant les zones de la couche diélectrique 1 qu'elle recouvre. Après cela, il est possible de procéder à une autre gravure en se servant de la seconde couche de résine 14 comme d'un second masque pour éliminer la couche de recouvrement 11 (figure 3H) à l'emplacement des lignes d'interconnexion 5. La seconde couche de résine 14 est alors enlevée (figure 3I) , après quoi une nouvelle gravure est effectuée pour créer dans la sous-couche supérieure 3 de la couche diélectrique 1 des cavités 17 aux emplacements des lignes d'interconnexion 5 tout en approfondissant les cavités 16 jusqu'à parvenir aux parties conductrices en dessous de la couche diélectrique 1 qui doivent être connectées (figure 3J). Les étapes menant aux figures 3I et 3J peuvent cependant être interverties.

La figure 3K représente l'état du circuit intégré après qu'on a déposé un matériau conducteur destiné à former les points de connexion 4 et les lignes d'interconnexion 5 sur les sous-couches diélectriques 2, 3 et la couche de recouvrement 11. Le matériau conducteur remplit les cavités 16 et 17 pour former les points de connexion 4 et les lignes d'interconnexion 5 et il se dépose au-dessus des lignes d'interconnexion 5 et de la couche de recouvrement 11 pour former une couche conductrice supérieure 18. Cette couche est plane dans certains cas, notamment si on dépose du tungstène ou du silicium polycristallin par voie chimique en phase vapeur.

La dernière étape consiste à graver uniformément ou "en plaque entière" la couche conductrice supérieure 18 pour la supprimer entièrement et arriver au produit fini représenté sur la figure 1.

Une réalisation simplifiée du procédé consiste à ne pas employer de couche de recouvrement 11 mais uniquement la couche de résine 12 comme premier masque. Après avoir creusé les cavités 13, on procède immédiatement à la gravure à mi-profondeur des cavités 16, après quoi on retire la couche de résine 12 pour la remplacer par la seconde couche de résine 14. On effectue ensuite les étapes de formation des cavités 15 ainsi que les étapes menant aux figures 3H à 3K. L'établissement de la seconde couche de résine 14 est toutefois rendu moins aisé car la résine pénètre dans les cavités 16 qui compromettent dans ces conditions la planéité de la couche.

Le procédé constitutif de l'invention peut être mis en oeuvre avec les matériaux et les techniques de dépôt, gravure, etc. usuels dans l'art. Le circuit intégré ainsi fabriqué peut avantageusement être une mémoire à semi-conducteur à accès aléatoire (RAM) ou une mémoire morte à programmation électrique (EPROM), et d'une façon générale tout circuit intégré dont la densité d'intégration est limitée par les techniques existantes, notamment ceux dont les dimensions caractéristiques sont inférieures au micromètre.

## Revendications

1. Procédé de réalisation d'un étage d'un circuit intégré constitué d'une couche diélectrique (1) enrobant des lignes d'interconnexion (5) et des points de connexion (4) reliant les lignes d'interconnexion (5) à des parties conductrices (6) du circuit intégré situées sous la couche diélectrique (1), la couche diélectrique (1) étant composée d'une sous-couche inférieure (2) enrobant les points de connexion (4) et d'une sous-couche supérieure (3) enrobant les lignes d'interconnexion (5), formé des étapes suivantes :
- dépôt de la couche diélectrique (1) ;
- établissement d'un premier masque (11, 12) sur la couche diélectrique (1), percé aux points de connexion ;
caractérisé par la succession des étapes suivantes :
- établissement d'un second masque, percé aux lignes d'interconnexion, (14) sur la couche diélectrique et le premier masque ;
- puis, gravure des portions de la couche diélectrique (1) exposées par le premier et le second masques, aux emplacements des points de connexion (4), sans atteindre les parties conductrices (6);
- enlèvement des portions du premier masque exposées par le second masque; puis, enlèvement du second masque;
- puis, gravure des portions de la couche diélectrique (1) exposées par le premier masque, aux emplacements des points de connexion jusqu'à atteindre les parties conductrices (6), et en même temps de la sous-couche supérieure (3) aux emplacements des lignes d'interconnexion (5) ;
puis, de façon connue :
- dépôt d'un matériau conducteur sur la couche diélectrique de manière à combler les parties gravées et former ainsi les points de connexion et les lignes d'interconnexion ; et
- élimination du matériau conducteur (18) en dessus de la couche diélectrique.

2. Procédé de fabrication d'un étage de circuit intégré suivant la revendication 1, caractérisé en ce que le premier masque comprend une couche de recouvrement (11) qui n'est pas ôtée des parties non gravées de la couche diélectrique avant de déposer le matériau conducteur.

3. Procédé de fabrication d'un étage de circuit intégré suivant la revendication 2, caractérisé en ce que la couche de recouvrement (11) est en silicium polycristallin, et le premier masque et le second masque comprennent chacun une couche de résine (12, 14) établie sur la couche de recouvrement (11) pour la graver successivement.

4. Procédé de fabrication d'un étage de circuit intégré suivant l'une quelconque des revendications 1 à 3, caractérisé en ce que le matériau conducteur est propre à former automatiquement une surface supérieure plane quand il est déposé.

## Patentansprüche

1. Verfahren zur Herstellung einer Stufe in einer integrierten Schaltung, gebildet durch eine dielektrische Schicht (1), Zwischenverbindungsleitungen (5) und Verbindungspunkte (4) umhüllend, die die Zwischenverbindungsleitungen (5) verbinden mit leitfähigen Teilen (6) der integrierten Schaltung, die sich unter der dielektrischen Schicht (1) befinden, wobei die dielektrische Schicht (1) zusammengesetzt ist aus einer unteren Teilschicht (2), die die Verbindungspunkte (4) umhüllt, und einer oberen Teil-Schicht (3), die die Zwischenverbindungsleitungen (5) umhüllt, gebildet durch die folgenden Schritte:
- Abscheiden der dielektrischen Schicht (1);
- Herstellen einer ersten Maske (11, 12) auf der dielektrischen Schicht (1), durchbrochen an den Verbindungspunkten;
**dadurch gekennzeichnet,** daß es nacheinander die folgenden Schritte umfaßt:
- Herstellen einer an den Zwischenverbindungsleitungen durchbrochenen zweiten Maske (14) auf der dielektrischen Schicht und der ersten Maske;
- Ätzen der durch die erste und die zweite Maske freigegebenen Teile der dielektrischen Schicht (1) an den Stellen der Verbindungspunkte (4), ohne die leitfähigen Teile (6) zu erreichen;
- Entfernen der durch die zweite Maske freigegebenen Teile der ersten Maske, sodann Entfernen der zweiten Maske;
- Ätzen der durch die erste Maske freigegebenen Teile der dielektrischen Schicht (1) an den Stellen der Verbindungspunkte (4) bis zum Erreichen der leitfähigen Teile (6) und gleichzeitig der Teilschicht (3) an den Stellen der Zwischenverbindungsleitungen (5);
dann, auf bekannte Weise:
- Abscheiden eines leitfähigen Materials auf der dielektrischen Schicht, um die geätzten Teile auszufüllen und so die Verbindungspunkte und die Zwischenverbindungsleitungen zu bilden; und
- Entfernen des leitfähigen Materials (18) oberhalb der dielektrischen Schicht.

2. Verfahren zum Herstellen einer Stufe in einer integrierten Schaltung nach Anspruch 1, dadurch gekennzeichnet, daß die erste Maske eine Abdeckungsschicht (11) umfaßt, die nicht vor dem Abscheiden des leitfähigen Materials entfernt wird von den nichtgeätzten Teilen der dielektrischen Schicht.

3. Verfahren zum Herstellen einer Stufe in einer integrierten Schaltung nach Anspruch 2, dadurch gekennzeichnet, daß die Abdeckungsschicht (11) aus polykristallinem Silicium ist und die erste Maske und die zweite Maske jeweils eine Harzschicht (12, 14) umfassen, hergestellt auf der Abdeckungsschicht (11), um sie nacheinander zu ätzen.

4. Verfahren zum Herstellen einer Stufe in einer integrierten Schaltung nach einem der Ansprüche 1 bis 3, dadurch gekennzeichnet, daß das leitfähige Material geeignet ist, automatisch eine plane obere Oberfläche zu bilden, wenn es abgeschieden wird.

## Claims

1. Process for producing an integrated circuit stage constituted by a dielectric layer (1) covering interconnection lines (5) and connection points (4) linking the interconnection lines (5) to conductive portions (6) of the integrated circuit positioned below the dielectric layer (1), the latter being constituted by a lower sublayer (2) covering the connection points (4) and an upper sublayer (3) covering the interconnection lines (5), formed by the following stages:
deposition of the dielectric layer (1);
producing a first mask (11,12) on the dielectric layer (1), perforated at the connection points: characterized in that by the following succession of stages:
and then in known manner:
deposition of a conductive material on the dielectric layer, so as to fill the etched portions and in this way form the connection points and interconnection lines; and
elimination of the conductive material (18) above the dielectric layer.

2. Process for producing an integrated circuit stage according to claim 1, characterized in that the first mask comprises a covering layer (11) which is not removed from the unetched parts of the dielectric layer (1) before depositing the conductive material.

3. Process for producing an integrated circuit stage according to claim 2, characterized in that the covering layer (11) is of polycrystalline silicon and the first and second masks each comprise a resin layer (12,14) on the covering layer (11) for successively etching it.

4. Process for producing an integrated circuit stage according to any one of the claims 1 to 3, characterized in that the conductive material is suitable for automatically forming a planar upper surface when deposited.
